# EUROPÄISCHE PATENTSCHRIFT

(11) **EP 0 504 460 B1**
(45) Veröffentlichungstag und Bekanntmachung des Hinweises auf die Patenterteilung: **01.02.1995**
(21) Anmeldenummer: 91104449.3
(22) Anmeldetag: 21.03.1991
(51) Int. Cl.: H03F 3/217

(54) **Hörgerät mit einer im Schaltbetrieb arbeitenden Endstufe**
Hearing aid with a switching amplifier output stage
Prothèse auditive avec un étage amplificateur de sortie à commutation

(43) Veröffentlichungstag der Anmeldung: 23.09.1992
(73) Patentinhaber: Siemens Audiologische Technik GmbH, 91058 Erlangen (DE)
(72) Erfinder: Gebert, Anton, W-8254 Kleinsendelbach (DE)
(74) Vertreter: Fuchs, Franz-Josef, Dr.-Ing.

(56) Entgegenhaltungen:
- FR-A- 2 646 031
- ELECTRONIC DESIGN. Bd. 25, Nr. 26, 20. Dezember1977, HASBROUCK HEIGHTS, NEW JERSEY Seiten 142 - 145; D.F. GEIGER: 'DRIVESERVOS WITH A SWITCHING AMPLIFIER'
- IEEE TRANSACTIONS ON INSTRUMENTATION AND MEASUREMENT. Bd. IM-36, Nr. 4,Dezember 1987, NEW YORK US Seiten 1001 - 1005; R.S. BURWEN: 'PARALLELABLE PWMAMPLIFIER'

## Beschreibung

Die Erfindung betrifft ein Hörgerät mit einem Verstärker und mit einer Gegentaktendstufe, die im Schaltbetrieb arbeitet und einen Hörer in einem Ausgangskreis in zeitlicher Abhängigkeit von einem Hörschallsignal mit einer Ultraschallfrequenz schaltet.

Aus der DE-PS 36 16 752 ist ein Hörgerät der eingangs genannten Art bekannt. Bei dem bekannten Hörgerät ist die im Schaltbetrieb arbeitende Gegentaktendstufe mit CMOS-Transistoren als Klasse D-Verstärker ausgebildet, in dessen Ausgangskreis ein Hörer angeordnet ist. Zu diesem Hörer ist ein Kondensator parallelgeschaltet. Zu der bekannten Parallelschaltung aus Kondensator und Hörer ist eine Induktivität in Reihe geschaltet. Die Induktivität und der Kondensator wirken im Ausgangskreis der als Brückenschaltung arbeitenden Gegentaktendstufe als Filter, das die im Ultraschallbereich liegende Schaltfrequenz unterdrücken soll. Die Schaltfrequenz kann z.B. 40 oder 100 kHz betragen.

Der Ausgangskreis des bekannten Schaltverstärkers (Gegentaktendstufe) weist stets eine relativ niedrige Impedanz auf, unter anderem wegen der niederohmig wirkenden CMOS-Transistoren (CMOS-Schalter). Wenn mit einem elektrisch parallel zum Hörer angeordneten Kondensator auch der Frequenzgang des Hörers (Tonfrequenzen ca. 1 bis 6 kHz) beeinflußt und/oder an die Endstufe angepaßt werden soll, müßte wegen der Niederohmigkeit des Ausgangskreises ein Kondensator mit sehr großer Kapazität verwendet werden. Ein derartiger Kondensator würde aber die Güte des Ausgangskreises des Schaltverstärkers erheblich vermindern. Daher kann keine Resonanzstelle in dem Frequenzgang des bekannten Schaltverstärkers auftreten. Folglich ist in bekannten Schaltverstärkern keine Beeinflussung des Frequenzganges des Hörers (Tonfrequenz-/ Sprachfrequenzbereich) durch einen dazu parallelgeschalteten Kondensator möglich. Eine derartige, mit einem Kondensator einstellbare Resonanzstelle ist aber zur Anpassung des Frequenzganges des jeweils verwendeten Hörers an den Schaltverstärker wünschenswert und bei nicht im Schaltbetrieb arbeitenden Endstufen auch üblich.

Aufgabe der Erfindung ist es, bei einem Hörgerät der eingangs genannten Art den Schaltverstärker so auszubilden, daß eine Beeinflussung des Frequenzganges des angeschlossenen Hörers durch einen dazu parallelgeschalteten Kondensator möglich wird.

Diese Aufgabe wird erfindungsgemäß durch die im Hauptanspruch genannten Merkmale gelöst. Dadurch lassen sich Hörer (unterschiedliche Hörertypen) mit verschiedenen Impedanzverläufen (Frequenzgängen) auch an im Schaltbetrieb arbeitende Gegentaktendstufen anpassen, was z.B. durch einen parallel zum Hörer geschalteten Kondensator geschehen kann.

Weitere Vorteile und Einzelheiten der Erfindung ergeben sich aus der nachfolgenden Beschreibung von Ausführungsbeispielen anhand der Zeichnungen und in Verbindung mit den Ansprüchen.

Es zeigen:
Figur 1 ein Hörgerät in symbolischer Darstellung mit einigen für die Erfindung wesentlichen prinzipiellen Schaltungsanordnungen;
Figur 2 ein Hörgerät gemäß Figur 1 mit einer Variante eines Rückkopplungsweges;
Figur 3 einen Impedanzverlauf eines an den Schaltverstärker anzupassenden Hörers;
Figur 4 eine Darstellung der Amplitudenbeeinflussung eines Eingangssignales (Hörschall) durch das erfindungsgemäße Hörgerät gemäß Figur 2 und
Figur 5 einen Hörer mit einem speziellen Auskoppelmittel in symbolischer Darstellung.

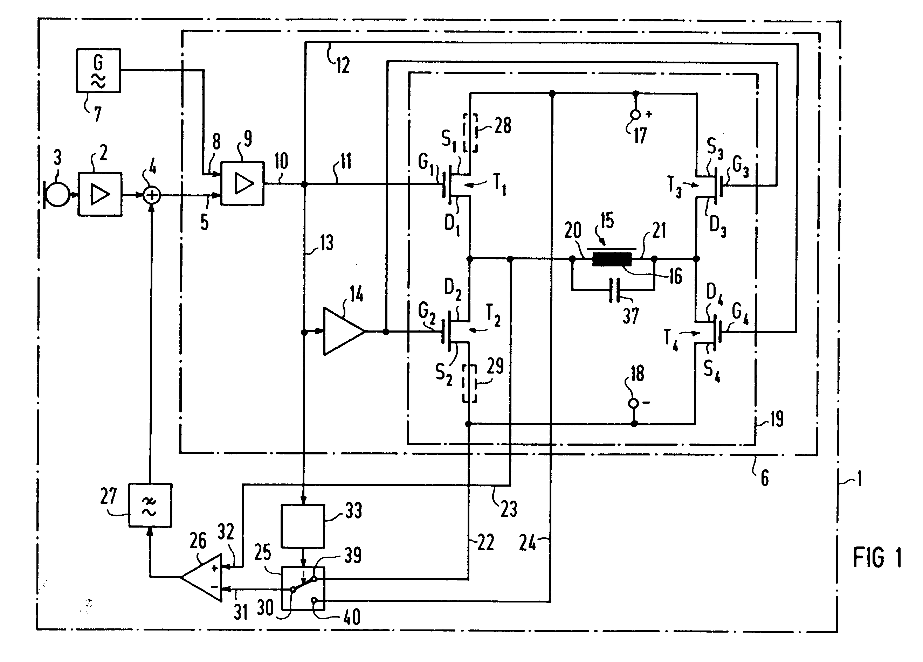

Figur 1 zeigt ein Hörgerät 1 mit einem Verstärker 2, der von einem Mikrofon 3 mit Hörschallsignalen gespeist wird und über ein Summierglied 4 mit einem Eingang 5 einer Gegentaktendstufe 6 (Schaltverstärker) verbunden ist. Ein Generator 7 erzeugt eine Ultraschallfrequenz, die in Form einer symmetrischen Dreieckspannung auf einen weiteren Eingang 8 der Endstufe 6 einwirkt. Die Endstufe 6 weist in diesem Ausführungsbeispiel eingangsseitig einen Komparator 9 auf. Der Komparator 9 formt aus den beiden Eingangssignalen (Hörschall und Ultraschall) ein Rechtecksignal im Ultraschallfrequenzbereich entsprechend der Ultraschallfrequenz des Generators 7. Das Rechtecksignal weist Impulse unterschiedlicher Zeitdauer auf. Die unterschiedliche Zeitdauer der einzelnen Impulse ergibt sich gemäß der bekannten Wirkungsweise eines Komparators einerseits aus dem Momentanwert der Amplitude des Hörschallsignales am Eingang 5 und andererseits aus der variablen (dreieckförmigen) Schwellenspannung des Ultraschallsignals am Eingang 8 des Komparators 9. Folglich steht an einem Ausgang 10 des Komparators 9 ein Rechtecksignal zur Verfügung, bei dem die Dauer der Einzelimpulse von dem Hörschallsignal abhängig ist, entsprechend einer bekannten Pulsdauermodulation.

Mit dem am Ausgang 10 des Komparators 9 zur Verfügung stehenden Rechtecksignal werden Halbleiter geschaltet, die in diesem Ausführungsbeispiel als komplementäre CMOS-Transistoren T₁ bis T₄ ausgebildet sind. Zu diesem Zweck ist der Ausgang 10 des Komparators 9 über eine Leitung 11 mit dem Gate-Anschluß G₁ des Transistors T₁ und über eine Leitung 12 mit dem Gate-Anschluß G₄ des Transistors T₄ verbunden. Des weiteren ist der Ausgang 10 des Komparators 9 über eine Leitung 13 mit einem Inverter 14 verbunden, in welchem das Rechtecksignal zur Steuerung (zum Schalten) der Komplementärtransistoren T₂ und T₃ invertiert wird. Folglich werden die Transistoren T₂ und T₃ über deren Gate-Anschlüsse G₂ bzw. G₃ mit einem komplementären Rechtecksignal geschaltet. Die Transistoren T₁ bis T₄ sind in diesem Ausführungsbeispiel in einer Brückenschaltung angeordnet, wobei ein Hörer 15 bzw. dessen Spule 16 Bestandteil eines Brückenzweiges zwischen den Transistoren T₁/T₂ und T₃/T₄ ist. Die Brückenschaltung wird über den positiven Betriebsspannungsanschluß 17 und den negativen Betriebsspannungsanschluß 18 mit einer Stromquelle, z.B. mit einer nicht dargestellten Hörgerätebatterie, verbunden.

Die als Brückenschaltung angeordneten Transistoren T₁ bis T₄ und der Hörer 15 sind zugleich Bestandteil eines Ausgangskreises 19 der Endstufe 6. Die Endstufe 6 arbeitet im Gegentakt. Dabei sind die Transistoren T₂ und T₃ oder die Transistoren T₁ und T₄ gleichzeitig leitend. Zur Beschreibung des Stromflusses wird zur Vereinfachung die Wirkung der Hörerimpedanz zunächst nicht berücksichtigt. Folglich fließt (vereinfacht ausgedrückt) der Strom im Ausgangskreis 19 während eines ersten Schaltzustandes, z.B. ausgehend von dem Betriebsspannungsanschluß 17, über einen Sourceanschluß S₃ und einen Drainanschluß D₃ des leitend geschalteten Transistors T₃, sodann über die Spule 16 des Hörers 15 und über den Drainanschluß D₂ und den Sourceanschluß S₂ des leitend geschalteten Transistors T₂ zu dem Betriebsspannungsanschluß 18. Wenn dagegen im anderen Fall die Transistoren T₂ und T₄ leitend geschaltet sind, fließt der Strom ausgehend von dem Betriebsspannungsanschluß 17 über einen Sourceanschluß S₁ und einen Drainanschluß D₁ des Transistors T₁, in entgegengesetzter Richtung über die Hörerspule 16 zu einem Drainanschluß D₄ und einem Sourceanschluß S₄ des Transistors T₄ zu dem negativen Betriebsspannungsanschluß 18.

Der wahre Stromfluß ist aber erheblich komplexer, weil der Hörer 15 für den mit einer Ultraschallfrequenz wechselnden Strom keinen rein ohmschen Widerstand darstellt, sondern ein frequenzabhängiger Widerstand (eine Impedanz) ist. Der Hörer 15 wirkt daher auch als Stromspeicher. Die Speicherwirkung wird von der Dauer der Einzelimpulse beeinflußt. Man kann daher auch davon sprechen, daß der Hörer 15 im Ausgangskreis 19 der Endstufe 6 durch die mit einer Ultraschallfrequenz gesteuerten Transistoren T₁ bis T₄ mit der Häufigkeit der vom Generator 7 abgegebenen Ultraschallfrequenz und in zeitlicher Abhängigkeit von der Amplitude des Hörschallsignals am Eingang 5 des Komparators 9 umgepolt wird. Folglich wechselt die an den beiden Anschlüssen 20 und 21 des Hörers 15 über die Transistoren T₁ bis T₄ angeschaltete Spannung ihre Polarität entsprechend der Schaltfrequenz und entsprechend der Dauer der einzelnen Impulse. Durch diesen Schaltbetrieb entstehen die eingangs geschilderten Nachteile in dem Ausgangskreis 19.

Erfindungsgemäß ist zur Erhöhung der Impedanz des Ausgangskreises 19 ein Rückkopplungsweg vorgesehen, der in diesem Ausführungsbeispiel Leitungen 22 bis 24, einen elektronischen Schalter 25, einen Differenzverstärker 26, einen Tiefpaßfilter 27 und das Summierglied 4 umfaßt. Die jeweils leitend geschalteten Transistoren T₁ bis T₄ weisen in dem leitenden Zustand jeweils sogenannte Durchgangswiderstände (intern) auf. Diese Durchgangswiderstände sind in der Figur 1 an den Sourceanschlüssen S₁ und S₂ durch strichliert gezeichnete Widerstandssymbole 28 und 29 dargestellt. Der Durchgangswiderstand 28 erscheint, wenn T₁ leitend ist und der Durchgangswiderstand 29 erscheint, wenn T₂ leitend ist.

Gemäß einem Ausführungsbeispiel der Erfindung werden die Durchgangswiderstände 28 und 29 als Auskoppelmittel verwendet, über welche ein von dem Schaltzustand des Hörers 15 abhängiges elektrisches Signal entnehmbar ist. Die in Figur 1 gezeichneten Durchgangswiderstände 28 und 29 sind körperlich nicht als separates Bauteil vorhanden, sondern erscheinen innerhalb der Transistoren T₁ bzw. T₂ wechselweise immer dann, wenn die Halbleiter T₁ bzw. T₂ mit der Ultraschallfrequenz gegenphasig leitend geschaltet werden. Folglich kann über den Transistor T₁ mittels der Leitungen 23 und 24 sowie über den Transistor T₂ mittels der Leitungen 22 und 23 das vom Schaltzustand des Hörers 15 abhängige elektrische Signal entnommen werden. Der elektronische Schalter 25 weist einen Eingangspol 39 auf, der mit der Leitung 22 des einen Rückkopplungsweges verbunden ist. Ein weiterer Eingangspol 40 des Schalters 25 ist mit der Leitung 24 des anderen Rückkopplungsweges verbunden. Ein Ausgangspol 30 am Schalter 25 ist mit einem Eingang 31 des Differenzverstärkers 26 verbunden. Ein anderer Eingang 32 am Differenzverstärker 26 ist mit der weiteren (gemeinsamen) Leitung 23 der zuvor genannten Rückkopplungswege verbunden. Der elektronische Schalter 25 ist in diesem Ausführungsbeispiel über eine Schaltersteuerung 33 mit dem Ausgang 10 des Komparators 9 verbunden. Folglich wird der Schalter 25 von einem von der Ultraschallfrequenz abhängigen Schaltsignal gesteuert. Damit können die aus beiden Auskoppelmitteln 28 und 29 entnommenen und vom Schaltzustand des Hörers 15 abhängigen elektrischen Signale phasenrichtig auf die Endstufe 6 zur Erhöhung der Impedanz des Ausgangskreises 19 einwirken.

Wesentliche Vorteile dieses speziellen erfindungsgemäßen Ausführungsbeispieles bestehen darin, daß als Auskoppelmittel in der Endstufe 6 für einen anderen Zweck erforderliche Bauteile (Transistoren) verwendet werden. Daher wird kein zusätzliches Bauteil als Auskoppelmittel benötigt. Da die Durchgangswiderstände 28 und 29 ohmschen Charakter haben und im übrigen mit dem Hörer 15 eine Reihenschaltung bilden, ist über diese Auskoppelmittel 28 und 29 ohne weiteres eine dem Hörerstrom proportionale Spannung als Rückkopplungssignal entnehmbar. Ganz wesentlich ist dabei auch, daß durch den Fortfall von zusätzlichen (separaten) Auskoppelmitteln im Ausgangskreis 19 der Endstufe 6 kein zusätzlicher Spannungsabfall entstehen kann, der den Wirkungsgrad bzw. die Ausgangsleistung der Endstufe 6 vermindern würde. Bei derartigen Hörgeräten wirken sich nämlich schon kleinste Spannungsabfälle störend aus, da die Hörgeräte im allgemeinen mit Betriebsspannungen von nur ca. 1,3 V betrieben werden.

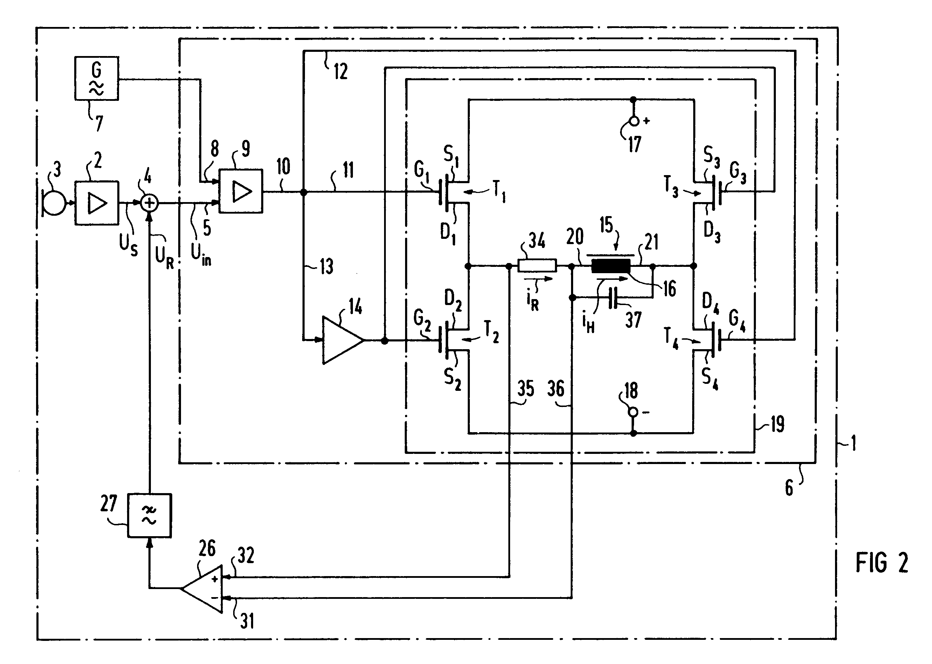

Ein weiteres spezielles Ausführungsbeispiel ist in Figur 2 dargestellt. In diesem Ausführungsbeispiel sind im wesentlichen nur der Rückkopplungsweg und das Auskoppelmittel gegenüber dem Ausführungsbeispiel gemäß Figur 1 anders ausgebildet. Als Auskoppelmittel wird gemäß Figur 2 ein Widerstand 34 verwendet. Der Widerstand 34 ist innerhalb eines Brückenzweiges zwischen den Transistoren T₁/T₂ und T₃/T₄ mit dem Hörer 15 in Reihe geschaltet. Folglich entsteht an dem einen Widerstand 34 in jedem Schaltzustand des Hörers ein Spannungsabfall, der als ein von dem Schaltzustand des Hörers abhängiges elektrisches Signal über Leitungen 35 und 36 zu den Eingängen 32 und 31 des Differenzverstärkers 26 geführt wird. Durch die spezielle Anordnung des Auskoppelwiderstandes 34 im Brückenzweig des Ausgangskreises 19 entfällt in vorteilhafter Weise die in Figur 1 dargestellte Umschalteinrichtung, die den Schalter 25 und die Schaltersteuerung 33 umfaßt. Das Tiefpaßfilter 27 kann eine Grenzfrequenz von 10 kHz aufweisen, so daß Tonfrequenzen (Hörschall) durchgelassen und die die Endstufe 6 umschaltende Ultraschallfrequenz gesperrt wird. Bei entsprechender Auslegung der Endstufe 6 bzw. des Ausgangskreises 19 mit einem die Ultraschallfrequenz sperrenden Filter und geeigneter Ankopplung des Rückkopplungsweges kann das Tiefpaßfilter 27 im Rückkopplungsweg auch entfallen.

Mit den beiden anhand der Figuren 1 und 2 beschriebenen Varianten eines Hörgerätes 1 gemäß der Erfindung läßt sich die Impedanz des Ausgangskreises 19 so weit erhöhen, daß unterschiedliche Hörer 15 mit Hilfe eines Kondensators 37 an die im Schaltbetrieb arbeitende Gegentaktendstufe 6 des Hörgerätes 1 anpaßbar und der Frequenzgang des jeweils verwendeten Hörers 15 durch einen dazu parallelgeschalteten Kondensator 37 beeinflußbar ist. Insbesondere entsteht durch die erfindungsgemäße Ausbildung des Hörgerätes eine höhere Güte des Ausgangskreises, durch die eine Überhöhung (Resonanz) im Frequenzgang des Ausgangskreises auftritt, die mit dem Kondensator 37 einstellbar ist.

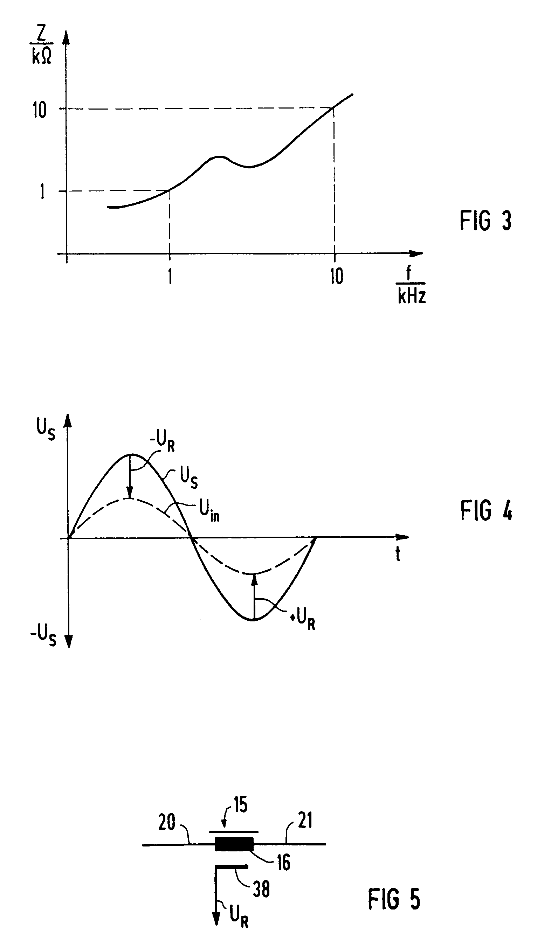

Die Wirkungsweise der Rückkopplung bei einem erfindungsgemäßen Hörgerät wird anhand der Figur 2 in Verbindung mit den Figuren 3 und 4 kurz (vereinfacht) beschrieben. Figur 3 zeigt den Impedanzverlauf eines Hörers 15, der je nach Hörertyp verschieden sein kann. Die Impedanz des Hörers 15 beträgt im vorliegenden Beispiel gemäß Figur 3 bei 1 kHz etwa 1 kOhm und bei 10 kHz etwa 10 kOhm. In Figur 4 ist mit der durchgehenden Kurve U_{S} das Hörschallsignal dargestellt, das am Ausgang des Verstärkers 2 sowie an einem damit verbundenen Eingang des Summiergliedes 4 gemäß Figur 2 anliegt. Die in Figur 4 strichliert gezeichnete Kurve Uᵢₙ stellt eine Spannung dar, die in Figur 2 am Eingang 5 der Komparatorschaltung 9 als Spannung Uᵢₙ anliegt. Die Differenz zwischen den beiden Spannungen U_{S} und Uᵢₙ ergibt sich aus dem vom Schaltzustand des Hörers abhängigen Signal -U_{R} bzw. +U_{R}; vergleiche die beiden entsprechenden Pfeile in Figur 4. In Figur 2 wird die Spannung U_{R} ebenfalls einem Eingang des Summiergliedes 4 zugeführt und wurde aus einem Spannungsabfall i_{R} am Widerstand 34 über den Differenzverstärker 26 erzeugt. Der Strom i_{R} ist proportional zu dem Hörerstrom i_{H}. Der Hörerstrom i_{H} nimmt mit zunehmender Impedanz des Hörers 15 ab. Folglich wird auch die Spannung U_{R} kleiner. Dadurch wird im Summierglied 4 weniger von der Spannung U_{S} subtrahiert, so daß im Ergebnis die Spannung Uᵢₙ am Eingang 5 des Komparators 9 größer wird. Daraus folgt eine längere Impulsdauer am Ausgang 10 des Komparators 9. Das führt wiederum zu einer längeren Durchschaltdauer der Transistoren (Schalter), z.B. T₁ und T₄. Sonach entsteht im Brückenzweig des Ausgangskreises 19 eine längere Integrationszeit des Hörerstromes i_{H} und des Stromes i_{R}, was einer Stromerhöhung gleichkommt. Das ursprüngliche Absinken von i_{R} ist dadurch weitgehend ausgeglichen worden.

In den beiden beschriebenen Ausführungsbeispielen gemäß den Figuren 1 und 2 wurde die Gegentaktendstufe 6 als Brückenschaltung in einem Ausgangskreis 19 betrieben. Es ist aber auch möglich, bei einem erfindungsgemäßen Hörgerät die Gegentaktendstufe nicht in Brückenschaltung zu betreiben. So kann die Endstufe z.B. nur zwei Transistoren aufweisen, die über einen Hörer mit Mittenanzapfung gespeist wird.

Figur 5 zeigt einen weiteren Hörer 15 mit einer Spule 16 sowie den Anschlüssen 20 und 21, der gemäß Figur 1 bzw. 2 in dem Brückenzweig des Ausgangskreises 19 angeordnet sein kann. Nach einer weiteren Variante der Erfindung ist in Figur 5 als Auskoppelmittel eine Sonde 38 induktiv mit der Spule 16 des Hörers 15 gekoppelt. Die Sonde 38 kann in dem zugehörigen Gehäuse (nicht dargestellt) des Hörers 15 untergebracht sein. Die Sonde 38 kann dabei auch als Sekundärwicklung der Spule 16 ausgebildet werden. Die Rückkopplungsspannung U_{R} kann einpolig (wie dargestellt) oder zweipolig zum Differenzverstärker 26 geführt werden.

## Patentansprüche

1. Hörgerät mit einem Verstärker (2) und mit einer Gegentaktendstufe (6), die im Schaltbetrieb arbeitet und einen Hörer (15) in einem Ausgangskreis (19) in zeitlicher Abhängigkeit von einem Hörschallsignal mit einer Ultraschallfrequenz schaltet, wobei die Endstufe wenigstens ein Auskoppelmittel (28, 29; 34; 38) aufweist, über welches ein von dem Schaltzustand des Hörers (15) abhängiges elektrisches Signal (U_{R}) entnehmbar ist, das über wenigstens einen Rückkopplungsweg (22 bis 27; 35, 36, 26, 27) auf die Endstufe (6) zur Erhöhung der Impedanz des Ausgangskreises (19) einwirkt.

2. Hörgerät nach Anspruch 1, wobei das Auskoppelmittel (34) mit dem Hörer (15) eine Reihenschaltung bildet.

3. Hörgerät nach Anspruch 1 oder 2, wobei das aus dem Auskoppelmittel (28, 29; 34; 38) ausgekoppelte Signal (U_{R}) eine dem Hörerstrom proportionale Spannung ist.

4. Hörgerät nach einem der Ansprüche 1 bis 3, wobei das Auskoppelmittel ein in den Ausgangskreis (19) angeordneter Widerstand (28, 29; 34) ist.

5. Hörgerät nach einem der Ansprüche 1 bis 4, wobei ein in der Endstufe (6) vorhandenes Bauteil (T₁, T₂) als Auskoppelmittel mit verwendet ist.

6. Hörgerät nach einem der Ansprüche 1 bis 5, wobei als Auskoppelmittel der jeweilige Durchgangswiderstand (28, 29) verwendet wird, welcher an zwei mit der Ultraschallfrequenz gegenphasig leitend geschalteten Halbleiterbauteilen (T₁, T₂) der Endstufe (6) wechselweise erscheint.

7. Hörgerät nach Anspruch 6, wobei von jedem der beiden Halbleiterbauteile (T₁, T₂) wenigstens eine Leitung (22, 23, 24) des jeweiligen Rückkopplungsweges (22 bis 27) zu jeweils einem Eingangspol (39, 40) eines elektronischen Umschalters (25) geführt ist, wobei der Umschalter (25) von einem von der Ultraschallfrequenz abhängigen Schaltsignal gesteuert wird und über einen Ausgangspol (30) mit einem Eingang (31) eines Differenzverstärkers (26) im Rückkopplungsweg verbunden ist.

8. Hörgerät nach einem der Ansprüche 1 bis 7, wobei das über das Auskoppelmittel (28, 29; 34; 38) entnommene Signal einem Summierglied (4) zugeführt ist, das mit einem Eingang (5) der im Schaltbetrieb arbeitenden Endstufe (6) verbunden ist.

9. Hörgerät nach einem der Ansprüche 1 bis 3, wobei das Auskoppelmittel als ein induktiv wirkendes Mittel (38) ausgebildet ist.

10. Hörgerät nach einem der Ansprüche 1 bis 3, wobei das Auskoppelmittel als eine mit der Spule (16) des Hörers (15) gekoppelte Sonde (38) ausgebildet ist.

## Claims

1. Hearing aid with an amplifier (2) and with a push-pull output stage (6) which operates in switching operation and connects an earphone (15) in an output circuit (19) in temporal dependence upon an audible sound signal with an ultrasonic frequency, whereby the output stage has at least one decoupling means (28, 29; 34; 38), by way of which an electrical signal (U_{R}) dependent on the switching state of the earphone (15) can be removed, which acts by way of at least one feedback path (22 to 27; 35, 36, 26, 27) on the output stage (6) to increase the impedance of the output circuit (19).

2. Hearing aid according to claim 1, whereby the decoupling means (34) forms a series connection with the earphone (15).

3. Hearing aid according to claim 1 or 2, whereby the signal (U_{R}) decoupled from the decoupling means (28, 29; 34; 38) is a voltage proportional to the earphone current.

4. Hearing aid according to one of claims 1 to 3, whereby the decoupling means is a resistor (28, 29; 34) arranged in the output circuit (19).

5. Hearing aid according to one of claims 1 to 4, whereby a component (T₁, T₂) present in the output stage (6) is also used as decoupling means.

6. Hearing aid according to one of claims 1 to 5, whereby that respective volume resistance (28, 29) is used as decoupling means which appears alternately at two semiconductor components (T₁, T₂) of the output stage (6) which are connected to the ultrasonic frequency in a conducting manner in phase opposition to the ultrasonic frequency.

7. Hearing aid according to claim 6, whereby of each of the two semiconductor components (T₁, T₂) at least one line (22, 23, 24) of the respective feedback path (22 to 27) is guided to a respective input pole (39, 40) of an electronic changeover switch (25), whereby the changeover switch (25) is controlled by a switching signal dependent on the ultrasonic frequency and is connected by way of an output pole (30) to an input (31) of a difference amplifier (26) in the feedback path.

8. Hearing aid according to one of claims 1 to 7, whereby the signal removed by way of the decoupling means (28, 29; 34; 38) is supplied to a summation element (4) which is connected to an input (5) of the output stage (6) operating in switching operation.

9. Hearing aid according to one of claims 1 to 3, whereby the decoupling means are constructed as means (38) acting in an inductive manner.

10. Hearing aid according to one of claims 1 to 3, whereby the decoupling means are constructed as a probe (38) coupled to the coil (16) of the earphone (15).

## Revendications

1. Appareil de correction auditive comportant un amplificateur (2) et un étage final symétrique (6), qui fonctionne selon le mode de commutation et active un écouteur (15) situé dans un circuit de sortie (19), selon une dépendance temporelle vis-à-vis d'un signal acoustique possédant une fréquence ultrasonique, I'étage final possédant au moins un moyen de découplage (28,29;34;38), au moyen duquel peut être prélevé un signal électrique (U_{R}), qui dépend de l'état de commutation de l'écouteur (15) et qui agit, par l'intermédiaire d'au moins une branche de réaction (22 à 27; 35, 36, 26, 27), sur l'étage final (6) pour accroître l'impédance du circuit de sortie (19).

2. Appareil de correction auditive suivant la revendication 1, dans lequel le moyen de découplage (34) forme, avec l'écouteur (15), un circuit série.

3. Appareil de correction auditive suivant la revendication 1 ou 2, dans lequel le signal (U_{R}), qui est découplé du moyen de découplage (28,29;34;38), est une tension proportionnelle au courant de l'écouteur.

4. Appareil de correction auditive suivant l'une des revendications 1 à 3, dans lequel le moyen de découplage est une résistance (28,29;34) disposée dans le circuit de sortie (19).

5. Appareil de correction auditive suivant l'une des revendications 1 à 4, dans lequel un composant (T₁, T₂) présent dans l'étage final (6) est utilisé conjointement en tant que moyen de découplage.

6. Appareil de correction auditive suivant l'une des revendications 1 à 5, dans lequel on utilise comme moyen de découplage, la résistance respective de passage (28,29), qui apparaît alternativement dans deux composants à semiconducteurs (T₁, T₂) de l'étage final (6), qui sont placés à l'état conducteur en opposition de phase, par la fréquence ultrasonique.

7. Appareil de correction auditive suivant la revendication 6, dans lequel au moins un conducteur (22,23,24) de la branche de réaction respective (22 à 27) part de chacun des deux composants à semiconducteurs (T₁, T₂) pour atteindre respectivement un pôle d'entrée (39,40) d'un commutateur électronique (25), le commutateur (25) étant commandé par un signal de commutation qui dépend de la fréquence ultrasonique, et étant relié, par l'intermédiaire d'un pôle de sortie (30), à une entrée (31) d'un amplificateur différentiel (26) dans la branche de réaction.

8. Appareil de correction auditive suivant l'une des revendications 1 à 7, dans lequel le signal prélevé par l'intermédiaire du moyen de découplage (28,29; 34,38) est envoyé à un circuit additionneur (4), qui est relié à une entrée (5) de l'étage final (6) opérant dans le mode de commutation.

9. Appareil de correction auditive suivant l'une des revendications 1 à 3, dans lequel le moyen de découplage est réalisé sous la forme d'un moyen (38) à action inductive.

10. Appareil de correction auditive suivant l'une des revendications 1 à 3, dans lequel le moyen de découplage est agencé sous la forme d'une sonde (38) couplée à la bobine (16) de l'écouteur (15).
